# EUROPEAN PATENT SPECIFICATION

(11) **EP 0 307 233 B1**
(45) Date of publication and mention of the grant of the patent: **12.07.1995**
(21) Application number: 88308363.6
(22) Date of filing: 09.09.1988
(51) Int. Cl.: H01L 31/0203, H01L 31/0216

(54) **Photoelectric converting apparatus**
Bauelement zur photoelektrischen Verwandlung
Appareil de convertion photoélectrique

(30) Priority: 11.09.1987 JP 226710/87; 06.09.1988 JP 221252/87
(43) Date of publication of application: 15.03.1989
(73) Proprietor: CANON KABUSHIKI KAISHA, Tokyo (JP)
(72) Inventor: Matsumoto, Shigeyuki, Atsugi-shi Kanagawa-ken (JP)
(74) Representative: Beresford, Keith Denis Lewis

(56) References cited:
- EP-A- 0 232 184
- DE-A- 3 617 229
- US-A- 4 600 833
- US-A- 4 682 019
- PATENT ABSTRACTS OF JAPAN vol. 10, no. 244 (E-430)(2300) 22 August 1986 ; & JP-A-61 075 562
- PATENT ABSTRACTS OF JAPAN vol. 11, no. 61 (E-483)(2508) 25 February 1987 ; & JP-A-61 220 460
- IBM TECHNICAL DISCLOSURE BULLETIN. vol. 23, no. 1, 01 June 1980, NEW YORK, US, page 346 ; G. BREWER et al. : "Light-absorbing insulator layer"
- PATENT ABSTRACTS OF JAPAN vol. 12, no. 130 (E-603)(2977) 21 April 1988 ; & JP-A-62 256 479

## Description

The present invention relates to a method of manufacturing a resin sealed photo-electric conversion device and a resin sealed photo-electric conversion device having a light receiving section defined in a substrate, particularly for preventing a malfunction or the like which is caused due to light entering from portions other than a light receiving window and due to internal reflections.

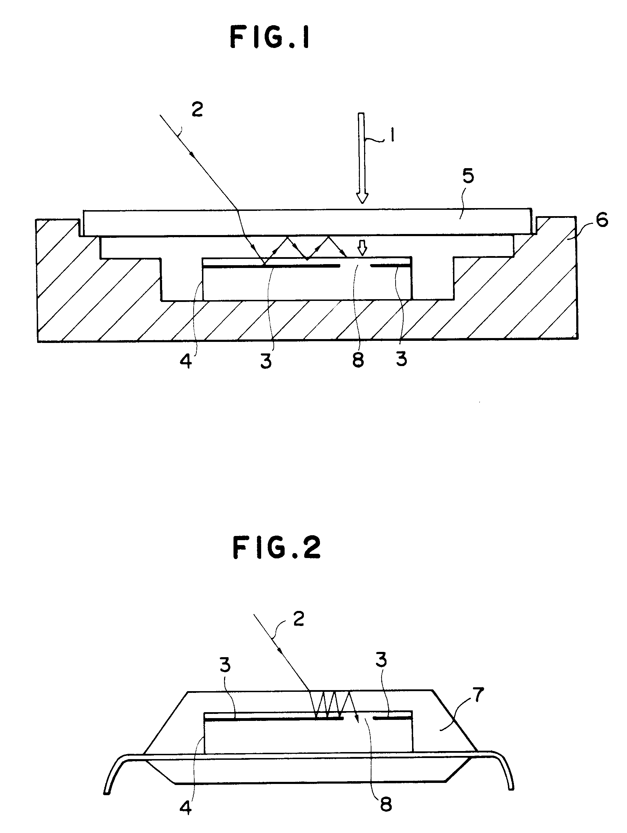

Figs. 1 and 2 are schematic arrangement diagrams of first and second examples of conventional photoelectric conversion devices.

In Fig. 1, a light shielding layer 3 is formed on the portions of a semiconductor chip 4 having photoelectric converting function excluding a light receiving portion 8. A whole construction is enclosed in a package 6 made of a material such as a plastic, ceramic or the like and sealed by a cover glass 5.

The light shielding layer 3 is provided for allowing necessary light 1 to be received by a semiconductor chip 4 and for shielding the unnecessary light. Al, Al-Si, or the like is used as a material of the light shielding film 3. The layer 3 is formed by a vacuum film forming technique such as an electron beam evaporation deposition process, sputtering process, CVD process, or the like. Usually, a sufficient thickness is about 200 nm (2000 Å).

However, in the foregoing conventional structure, when unnecessary light flux 2 is incident on the cover glass 5, light is totally internally reflected by the light shielding layer 3 and by the inner surface of the cover glass 5 and reaches the light receiving section 8, as shown in Fig. 1.

Therefore, a malfunction of the photoelectric converting device in the semiconductor chip 4 occurs, and there is a problem that the noise figure of the output signal increases.

The same problem arises in a case wherein the semiconductor chip 4 is enclosed in a clear mould package 7, the semi-conductor chip 4 having a light receiving element being enclosed within a transparent resin as shown in Fig. 2.

There is described in Patent Abstract of Japan, volume 10, No. 244 (E-430) [2300], August 22, 1986 and Japanese Kokai JP-A-61075562 a photo-electric conversion device comprising a substrate with a photo-electric conversion element defined therein, an inner insulating layer of silicon oxide and a layer of polysilicon covering the photoelectric conversion element and remainder major surface of the substrate, and a light shielding layer of aluminium covering the polysilicon layer so as to surround the periphery of the photoelectric conversion element. A reflection preventing layer of aluminium oxide is formed directly on the surface of the aluminium light shielding layer and this and an exposed area of the polysilicon layer are covered by a filter material. Notably, the aluminium oxide reflection preventing layer is produced by sputtering as a means of avoiding contamination of the substrate and deterioration of device characteristics.

The present invention is also directed as a solution to the problem of avoiding spurious light incidence upon the photo-electric conversion element. It also provides an alternative approach to solving the problem of avoiding contamination.

A method of manufacturing a resin-sealed photoelectric conversion device, and such resin-sealed photoelectric conversion device in accordance with the present invention are defined in claims 1 and 2 respectively.

In the accompanying drawings:-
Figs. 1 and 2 are schematic arrangement diagrams of first and second examples of conventional photo-electric conversion devices;
Fig. 3 is a schematic arrangement diagram of a substantial portion of a semiconductor chip in the first embodiment of a photo-electric conversion device according to the present invention; and
Fig. 4 is a schematic arrangement diagram of a second embodiment of the invention.

Embodiments of the present invention will be described in detail hereinbelow with reference to the drawings.

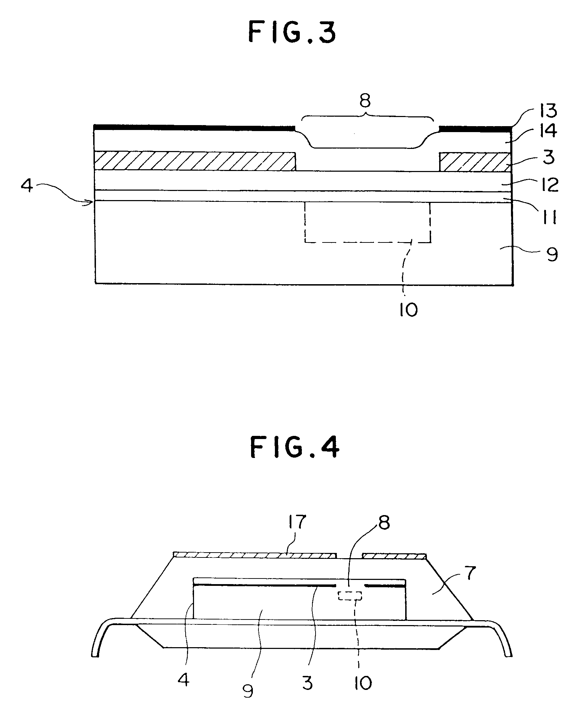

Fig. 3 is a schematic arrangement diagram of a substantial portion of a semiconductor chip in this the first embodiment of a photoelectric conversion device according to the invention.

In Fig. 3, a photo-electric conversion element 10 is formed in a semi-conductor substrate 9. An SiO₂ layer 11 and an insulative layer 12 are formed on and over the semiconductor substrate 9. Further, a light shielding layer 3 is formed on and over the insulative layer 12 excluding a light receiving section 8. An insulative layer 14 is formed on the insulative layer 12.

A reflection preventing layer 13 having the same pattern as the light shielding layer 3 is formed on the insulative layer 14. Thus, total internal reflection by the insulative layer 14 can be prevented.

In this embodiment, since the reflection preventing layer 13 is formed in the final layer forming step, it can be formed independently of the deposition conditions such as deposition temperature of the insulative layer 14 and a high heat resistance is not necessary. On the other hand, it is possible to avoid pollution of the film forming apparatus used for depositing the insulative layer 14.

When the foregoing semiconductor chip 4 of the above embodiment is enclosed in a clear mould package, even if unnecessary light fluxes 2 enter as in the examples shown in Figs. 1 and 2, they are absorbed by the reflection preventing layer 13 and do not reach the photo-sensing element 10.

A method of manufacturing this embodiment will now be described.

First, a step of forming the photo-sensing element 10 in the semiconductor substrate 9, a step of forming the SiO₂ layer 11, a wiring forming step, and a step of forming the insulative layer 12 are performed.

In the wiring forming step, Al or Al-Si is formed on the SiO₂ layer 11 by a sputtering method so as to have a thickness of 0.7 to 1.2 »m. Then, it is patterned to thereby form an aluminium or aluminium silicide wiring. The insulative layer 12 is made of highly insulative material such as silicon nitride or SiO₂. In the case of using silicon nitride, it is formed by a plasma CVD method, using a gas mixture, for example, SiH₄ + NH₃, at a layer forming temperature of 300 to 400°C. A refractive index nf = 2.01 ± 0.05 is achieved. A thickness 400 to 1200 nm (4000 to 12000 Å) of the layer is desirable.

An SiO₂ layer having a thickness of 30 to 200 nm (300 to 2000 Å) formed by a CVD method may be laid under silicon nitride as will be explained hereinafter.

In the case of SiO₂ layer, the insulative layer 12 is formed using a gas mixture, for example, SiH₄ + O₂ at a temperature of 350 to 450°C. so as to have a thickness of 600 to 1200 nm (6000 to 12000 Å) by a CVD method.

The insulative layer 14 may be formed under the same conditions and thickness as those of the insulative layer 12. The light shielding film 3 is formed by depositing a light shielding material such as Al or Al-Si or the like, whose thickness is 150 nm (1500 Å) or more by a sputtering method or electron beam evaporation deposition method, and by eliminating the light receiving portion 8 by the patterning.

Now the reflection preventing layer 13 will be explained in practical detail.

A reflection factor of the reflection preventing layer is chosen to be a small value preferably of 5% or less, more preferably, 1% or less. It is desirable to use a reflection preventing layer which can be easily patterned. Particularly, selecting, as a material of the reflection preventing layer or film, one which can be patterned by light is desirable. As such desirable material, the following can be used:

### (1) Photosensitive resin:

(a) Since a black photosensitive resin has a small reflection factor and can be patterned by light it can be used as a material of the reflection preventing layer.
   Such a photosensitive resin, for example, can be selected from the resins Nos. PI 2702 and 2703 made by Du Pont Co., Ltd. which are available commercially.
(b) Moreover, it is also possible to use as the reflection preventing material a material which is made by mixing the following pigment or dye with a photosensitive resin such as PIQ (photosensitive polyimide, a trade name, made by Hitachi Chemical Co., Ltd.)

As an organic pigment suitable for use, one or two kinds or more are selected from a group of azo system pigments of the soluble azo system, insoluble azo system, condensed azo system, or the like, a phthalocyanine system pigment, and condensed polycyclic system pigments including the indigo system, anthraquinone system, perylene system, perynone system, dioxazine system, quinacridone system, isoindolinone system, phthalone system, methine·azomethine system, and other metal complex system and mixed.

On the other hand, it is also possible to use inorganic pigment such as a carbon black, iron black, graphite, or a compound oxide black pigment of the copper chromium system, copper, iron, and manganese system.

As a dye, one, two, or three kinds or more can be selected from the dyes of various systems such as azo, anthraquinone, phthalocyanine, carbonium, quinonimine, methine, benzoquinone, naphthoquinone, and the like and mixed.

In the case of the semiconductor chip 4 shown in Fig. 3, after the insulative layer 14 has been formed, the photosensitive resin material of (a) or (b) compound is coated over the whole surface by a spin coater and exposed to ultraviolet rays using the same mask as used previously for defining the light shielding layer 3. The reflection preventing layer 13 is then formed by developing and rinsing steps. A thickness of 100 to 1000 nm (1000 to 10000 Å) of the layer is desirable.

The photosensitive resin material also has the light shielding effect because it is black and can be also used as the material of the reflection preventing layer 15 in the third embodiment.

### (2) Heat resisting binder system:

A mixture is made by mixing any of the above-mentioned pigments or dyes with OCD (Trade name: made by Tokyo Applied Chemical Co., Ltd.; OCD is obtained by binding SiO₂ in ethanol and has a concentration of 10% or less).

This mixture is coated onto the whole surface by using, for example, a spin coater and it is baked at temperatures of about 100 to 200°C in an atmosphere of N₂, thereby forming an inorganic silica film containing dye or pigment.

Subsequently, the inorganic silica film is patterned by a photographic etching technique using the same mask as used for defining the light shielding layer 3, thereby forming the reflection preventing layer 13.

The reflection preventing film can be also similarly formed by mixing the foregoing pigment or dye into a heat resisting resin such as polyamide or the like.

### (3) Inorganic film:

An inorganic film of a low reflectivity made of an inorganic material such as PbS, SnS, CuS, FeO, CuO, or the like is formed by a vacuum depositing method and patterned, so that the reflection preventing layer 13 can be formed.

On the other hand, a film consisting of Ti or Ti compound is formed and this film is left under the conditions of oxygen flow rate of 5 to 200 cc/min and a pressure of 1x10 to 4.0x10² Pa (0.1 to 3.0 Torr) and in the plasma of discharge power, 100 to 1000 kW. Thus, a black reflection preventing layer 13 having fine concave and convex surfaces can be formed.

In addition it is also possible to use a method of reducing the reflectivity by the interfering effect. A good result was obtained by depositing a film consisting of Si, TiO, Ge, Cr, Ti.

The present invention is not limited to the semiconductor chip 4 configuration in which the reflection preventing layer has been formed as in the foregoing embodiment. A similar effect can be derived even when the light shielding layer is formed on the outside of a resin mould package as will be explained hereinbelow.

Fig. 4 is a schematic arrangement diagram of a second embodiment of the invention.

In the second embodiment shown in Fig. 4, a reflection preventing layer 17 is formed on the upper surface of a clear mould package 7, so that unnecessary light can be absorbed (refer to Fig. 2).

As described in detail above, in both the photoelectric conversion devices, by forming a reflection preventing layer surrounding the periphery of the light receiving section, even if the unnecessary light flux enters it can be absorbed before reaching the light receiving section and adverse influence on the photoelectric converting operation can be prevented.

Consequently, a malfunction of the photoelectric conversion device due to the entrance of light from portions other than the light receiving window and a fluctuation of the output can be eliminated. The noise figure of the output is reduced. The reliability of the photoelectric conversion device can be improved.

## Claims

1. A method of manufacturing a resin sealed photoelectric conversion device comprising the steps of:
providing a substrate (9);
defining a photo-electric conversion element (10) in a major surface of said substrate (9);
covering said major surface of said substrate (9), including said photo-electric conversion element (10), with an inner insulating layer (12);
forming a patterned light shielding layer (3) on said inner insulating layer (12), which light shielding layer (3) surrounds the periphery of said photo-electric conversion element (10); and
covering said light shielding layer (3) and that part of said inner insulating layer (12) left exposed by said light shielding layer (3) with an outer insulating layer (14);
which method is characterised by:
surrounding said substrate (9) with a resin seal (7) and providing a reflection preventing layer (13,17) surrounding at least the periphery of said photoelectric conversion element (10) over said outer insulating layer (14) either directly on said outer insulating layer (14) in contact with said resin seal (7) or alternatively on the outer surface of said resin seal (7).

2. A resin sealed photoelectric conversion device comprising:
a substrate (9);
a photoelectric conversion element (10) defined in a major surface of said substrate (9);
an inner insulating layer (12) covering the major surface of said substrate (9);
a light shielding layer (3) for preventing incidence of unnecessary light on said photoelectric conversion element (10) located on said inner insulating layer (12) surrounding the periphery of said photoelectric conversion element (10);
an outer insulating layer (14) covering of said said light shielding layer (3) and that part of the inner insulating layer (12) left exposed by said light shielding layer (3); and
a resin seal (7) surrounding said substrate (9) wherein said device further comprises a reflection preventing layer (13, 17) at least surrounding the periphery of said photoelectric conversion element (10) and provided over said outer insulating layer (14), either directly on said outer insulating layer in contact with said resin seal (7) or alternatively on the outer surface of said resin seal (7).

3. A device according to claim 2, wherein said reflection preventing layer (13) is of resin material.

4. A device according to claim 3, wherein said resin is a developed photosensitive resin.

5. A device according to claim 3 or 4, wherein said resin contains a pigment.

6. A device according to claim 5, wherein said pigment is (a) at least one organic pigment selected from azo system, phthalocyanine system, and condensed polycyclic system pigments including indigo system, anthraquinone system, perylene system, perynone system, dioxazine system, quinacridone system, isoindolinone system, phthalone system, methine·azomethine system, and metal complex system and/or (b) at least one inorganic pigment selected from carbon black, iron black, graphite, and compound oxide black pigment of the copper chromium system, copper, iron and manganese system.

7. A device according to claim 3, wherein said resin contains a dye.

8. A device according to claim 7, wherein said dye comprises at least one selected from azo, anthraquinone, phthalocyanine, carbonium, quinonimime, methine, benzoquinone, naphthoquinone.

9. A device according to any of claims 3 to 8, wherein said resin contains SiO₂.

10. A device according to any of claims 4 to 9, wherein said resin is of polyamide.

11. A device according to claim 2, wherein said reflection preventing layer (13) is an inorganic film or layer.

12. A device according to claim 11, wherein said inorganic film or layer comprises a material selected from PbS, SnS, CuS, FeO, CuO, Ti, TiO, Ti-compound, Si, Ge and Cr.

13. A device according to any of claims 2 to 12, wherein said reflection preventing layer (13) has a reflectivity lower than 5%.

14. A device according to claim 2, wherein said light shielding layer (3) and said reflection preventing layer (13) have substantially the same configuration.

## Patentansprüche

1. Verfahren zur Herstellung einer mit Harz abgedichteten photoelektrischen Umwandlungsvorrichtung, umfassend die folgenden Schritte:
Bereitstellen eines Substrats (9);
Definieren eines photoelektrischen Umwandlungselements (10) in einer größeren Oberfläche des Substrats (9);
Bedecken der größeren Oberfläche des Substrats (9) mit dem photoelektrischen Umwandlungselement (10) mit einer inneren Isolierschicht (12);
Bilden einer strukturierten Licht-Abschirmschicht (3) auf der inneren Isolierschicht (12), wobei die Licht-Abschirmschicht (3) den Rand des photoelektrischen Umwandlungselements (10) umgibt; und
Bedecken der Licht-Abschirmschicht (3) und des Teils der inneren Isolierschicht (12), der von der Licht-Abschirmschicht (3) freigelegt blieb, mit einer äußeren Isolierschicht (14);
wobei das Verfahren dadurch gekennzeichnet ist, daß:
das Substrat (9) mit einer Harz-Abdichtung (7) umgeben wird und eine reflexionsverhindernde Schicht (13, 17) bereitgestellt wird, die mindestens den Rand des photoelektrischen Umwandlungselements (10) über der äußeren Isolierschicht (14) entweder direkt auf der äußeren Isolierschicht (14) in Berührung mit der Harz-Abdichtung (7) oder alternativ auf der Außenfläche der Harz-Abdichtung (7) umgibt.

2. Mit Harz abgedichtete photoelektrische Umwandlungsvorrichtung, umfassend:
ein Substrat (9);
ein photoelektrisches Umwandlungselement (10), das in einer größeren Oberfläche des Substrats (9) definiert ist;
eine innere Isolierschicht (12), die die größere Oberfläche des Substrats (9) bedeckt;
eine Licht-Abschirmschicht (3) zum Verhindern, daß unnötiges Licht auf das photoelektrische Umwandlungselement (10) einfällt, die sich auf der inneren Isolierschicht (12) befindet, wobei sie den Rand des photoelektrischen Umwandlungselements (10) umgibt;
eine äußere Isolierschicht (14), die die Licht-Abschirmschicht (3) und den Teil der inneren Isolierschicht (12), der von der Licht-Abschirmschicht (3) freigelegt blieb, bedeckt; und
eine Harz-Abdichtung (7), die das Substrat (9) umgibt, wobei die Vorrichtung ferner eine reflexionsverhindernde Schicht (13, 17) umfaßt, die mindestens den Rand des photoelektrischen Umwandlungselements (10) umgibt und über der äußeren Isolierschicht (14) bereitgestellt ist, entweder direkt auf der äußeren Isolierschicht in Berührung mit der Harz-Abdichtung (7) oder alternativ auf der äußeren Oberfläche der Harz-Abdichtung (7).

3. Vorrichtung nach Anspruch 2, wobei die reflexionsverhindernde Schicht (13) aus einem Harzmaterial ist.

4. Vorrichtung nach Anspruch 3, wobei das Harz ein entwickeltes lichtempfindliches Harz ist.

5. Vorrichtung nach einem der Ansprüche 3 oder 4, wobei das Harz ein Pigment enthält.

6. Vorrichtung nach Anspruch 5, wobei das Pigment (a) mindestens ein organisches Pigment, ausgewählt aus Pigmenten des Azo-Systems, Phthalocyanin-Systems und kondensierten polyzyklischen Systems umfassend Indigo-System, Anthrachinon-System, Perylen-System, Perynon-System, Dioxazin-System, Chinacridon-System, Isoindolinon-System, Phthalon-System, Methin.Azomethin-System und Metallkomplexsystem und/oder (b) mindestens ein anorganisches Pigment, ausgewählt aus Ruß, Eisenschwarz, Graphit und Verbindungs-Oxidschwarzpigment vom Kupfer-Chrom-System, Kupfer-, Eisen- und Mangan-System ist.

7. Vorrichtung nach Anspruch 3, wobei das Harz einen Farbstoff enthält.

8. Vorrichtung nach Anspruch 7, wobei der Farbstoff mindestens einen, ausgewählt aus Azo-, Anthrachinon-, Phthalocyanin-, Carbonium-, Chinonimin-, Methin-, Benzochinon-, Naphthochinon-Farbstoffen umfaßt.

9. Vorrichtung nach einem der Ansprüche 3 bis 8, wobei das Harz SIO₂ enthält.

10. Vorrichtung nach einem der Ansprüche 4 bis 9, wobei das Harz aus Polyamid ist.

11. Vorrichtung nach Anspruch 2, wobei die reflexionsverhindernde Schicht (13) ein anorganischer Film oder eine anorganische Schicht ist.

12. Vorrichtung nach Anspruch 11, wobei der anorganische Film oder die anorganische Schicht ein Material umfaßt, das aus PbS, SnS, CuS, FeO, CuO, Ti, TiO, Ti-Verbindung, Si, Ge und Cr ausgewählt ist.

13. Vorrichtung nach einem der Ansprüche 2 bis 12, wobei die reflexionsverhindernde Schicht (13) ein Reflexionsvermögen niedriger als 5 % hat.

14. Vorrichtung nach Anspruch 2, wobei die Licht-Abschirmschicht (3) und die reflexionsverhindernde Schicht (13) im wesentlichen denselben Aufbau haben.

## Revendications

1. Procédé de fabrication d'un dispositif de conversion photoélectrique encapsulé dans la résine, comprenant les étapes qui consistent :
à utiliser un substrat (9) ;
à définir un élément de conversion photo-électrique (10) dans une surface principale dudit substrat (9) ;
à recouvrir ladite surface principale dudit substrat (9), y compris ledit élément de conversion photo-électrique (10), d'une couche isolante intérieure (12) ;
à former une couche (3) d'écran à la lumière suivant un motif sur ladite couche isolante intérieure (12), laquelle couche (3) d'écran à la lumière entoure la périphérie dudit élément de conversion photoélectrique (10) ; et
à recouvrir ladite couche (3) d'écran à la lumière et la partie de ladite couche isolante intérieure (12) laissée à découvert par ladite couche (3) d'écran à la lumière avec une couche isolante extérieure (14) ;
lequel procédé est caractérisé par le fait que :
on entoure ledit substrat (9) d'une capsule (7) de résine et on réalise une couche antiréflexion (13, 17) entourant au moins la périphérie dudit élément de conversion photoélectrique (10) au-dessus de ladite couche isolante extérieure (14), soit directement sur ladite couche isolante extérieure (14) en contact avec ladite capsule (7) de résine, soit, en variante, sur la surface extérieure de ladite capsule (7) de résine.

2. Dispositif de conversion photoélectrique encapsulé dans de la résine, comportant :
un substrat (9) ;
un élément de conversion photoélectrique (10) défini dans une surface principale dudit substrat (9) ;
une couche isolante intérieure (12) recouvrant la surface principale dudit substrat (9) ;
une couche (3) d'écran à la lumière destinée à empêcher l'incidence de lumière inutile sur ledit élément de conversion photoélectrique (10), et placée sur ladite couche isolante intérieure (12) entourant la périphérie dudit élément de conversion photoélectrique (10) ;
une couche isolante extérieure (14) recouvrant ladite couche (3) d'écran à la lumière et la partie de la couche isolante intérieure (12) laissée à découvert par ladite couche (3) d'écran à la lumière ; et
une capsule (7) de résine entourant ledit substrat (9), ledit dispositif comportant en outre une couche antiréflexion (13, 17) entourant au moins la périphérie dudit élément de conversion photoélectrique (10) et réalisée au-dessus de ladite couche isolante extérieure (14), soit directement sur ladite couche isolante extérieure en contact avec ladite capsule (7) de résine, soit, en variante, sur la surface extérieure de ladite capsule (7) de résine.

3. Dispositif selon la revendication 2, dans lequel ladite couche antiréflexion (13) est en matière du type résine.

4. Dispositif selon la revendication 3, dans lequel ladite résine est une résine photosensible développée.

5. Dispositif selon la revendication 3 ou 4, dans lequel ladite résine contient un pigment.

6. Dispositif selon la revendication 5, dans lequel ledit pigment est (a) au moins un pigment organique choisi parmi des pigments du type azoïque, du type phtalocyanine et du type polycyclique condensé comprenant des pigments du type indigo, du type anthraquinone, du type pérylène, du type pérynone, du type dioxazine, du type quinacridone, du type isoindolinone, du type phtalone, du type méthine azométhine et d'un complexe métallique et/ou (b) au moins un pigment inorganique choisi entre le noir de carbone, le noir de fer, le graphite et un pigment noir d'oxyde composé du système cuivre-chrome, et du système du cuivre, du fer et du manganèse.

7. Dispositif selon la revendication 3, dans lequel ladite résine contient un colorant.

8. Dispositif selon la revendication 7, dans lequel ledit colorant comprend au moins un colorant choisi parmi un colorant azoïque, une anthraquinone, la phtalocyanine, le carbonium, la quinonimine, la méthine, la benzoquinone et la naphtoquinone.

9. Dispositif selon l'une quelconque des revendications 3 à 8, dans lequel ladite résine contient du SiO₂.

10. Dispositif selon l'une quelconque des revendications 4 à 9, dans lequel ladite résine est formée d'un polyamide.

11. Dispositif selon la revendication 2, dans lequel ladite couche antiréflexion (13) est un film ou une couche inorganique.

12. Dispositif selon la revendication 11, dans lequel ledit film ou ladite couche inorganique comprend une matière choisie parmi PbS, SnS, CuS, FeO, CuO, Ti, TiO, un composé de Ti, Si, Ge et Cr.

13. Dispositif selon l'une quelconque des revendications 2 à 12, dans lequel ladite couche anti-réflexion (13) présente une réflectivité inférieure à 5 %.

14. Dispositif selon la revendication 2, dans lequel ladite couche (3) d'écran à la lumière et ladite couche antiréflexion (13) ont sensiblement la même configuration.
